Europäisches Patentamt

European Patent Office

Office européen des brevets

(11) Veröffentlichungsnummer: **0 181 951 B1**

(12) **EUROPÄISCHE PATENTSCHRIFT**

(45) Veröffentlichungstag der Patentschrift: 27.02.91

(21) Anmeldenummer: 84113891.0

(22) Anmeldetag: 16.11.84

(51) Int. Cl.⁵: **H03F 1/30**

(54) **Hochfrequenz-Leistungsverstärker.**

(43) Veröffentlichungstag der Anmeldung:
**28.05.86 Patentblatt 86/22**

(45) Bekanntmachung des Hinweises auf die
Patenterteilung:
**27.02.91 Patentblatt 91/09**

(84) Benannte Vertragsstaaten:
**AT DE FR GB IT SE**

(56) Entgegenhaltungen:
**EP-A- 0 036 042**
**FR-A- 1 373 477**
**US-A- 2 820 855**
**US-A- 3 074 024**
**US-A- 3 201 672**

**SIEMENS REVIEW, Band 43, Nr. 4, April 1976,**
**Seiten 171-175, Erlangen, DE; E. MÜNZBERG**
**u.a.: "Thyristor cubicles with closed-circuit**
**air/water cooling"**

**ELEKTRONIK, Band 13, Nr. 4, April 1964, Seite**
**104, München, DE; "Ein elektronisch geregel-**
**ter Thermostat"**

(73) Patentinhaber: **Richard Hirschmann Electric**
**Oberer Paspelsweg 6-8**
**A-6830 Rankweil-Brederis(AT)**

(72) Erfinder: **Hosp, Karl**
**Scheffelstrasse 6**
**A-6900 Bregenz(AT)**

(74) Vertreter: **Stadler, Heinz, Dipl.-Ing.**
**Richard-Hirschmann-Strasse 19 Postfach**
**110**
**D-7300 Esslingen a.N.(DE)**

## Beschreibung

Die Erfindung betrifft einen Hochfrequenz-Leistungsverstärker gemäß dem Oberbegriff des Patentanspruchs 1.

In derartigen, insbesondere als Endstufen von Fernsehsendern und -umsetzern verwendeten Verstärkern sind die Leistungstransistoren bei Nenntemperatur häufig über den linearen Teil der Kennlinie hinaus bis in den nichtlinearen Bereich hinein ausgesteuert. Die dabei entstehenden Intermodulationsprodukte werden zur Verringerung entsprechender Störungen durch in einem Vorentzerrer erzeugte Intermodulations-Signale gleicher Größe aber entgegengesetzter Phase kompensiert.

Verstärker dieser Art sind in zwei unterschiedlichen Ausführungen bekannt. Bei der einen, z.B. in dem Senderumsetzer TVM 430/100 der Anmelderin benutzten Lösung wird die Hochfrequenz-Ausgangsleistung konstant gehalten und die temperaturabhängige Verstärkungsänderung durch Regelung der Eingangsleistung mittels einer durch einen Hochfrequenz-Detektor am Ausgang gewonnen Regelspannung ausgeglichen. Mit steigender Temperatur verringert sich die Verstärkung, so daß durch die Regelung die Eingangsleistung und somit auch die Aussteuerung der Leistungstransistoren vergrößert wird. Auf diese Weise entstehen im Ausgangssignal in der Amplitude vergrößerte Intermodulationsträger, die dessen Qualität je nach Stärke der Temperaturerhöhung bis zur Unbrauchbarkeit verschlechtern können. Dies gilt insbesondere für Verstärker mit Vorentzerrer, da deren kompensierende Wirkung aufgrund der Abweichungen der auszugleichenden Träger sowohl hinsichtlich ihrer Größe als auch ihrer Gegenphasenlage nicht mehr in ausreichendem Maße besteht.

Bei der anderen, beispielsweise durch das Gerät des Typs NM 1421-100 der Firma Norsk Marconi bekannten Verstärkerart mit mehreren zur Erzielung der erforderlichen Hochfrequenz-Ausgangsleistung parallel geschalteten Leistungstransistoren wird die Eingangsleistung des Leistungsverstärkers konstant gehalten, damit bei Ausfall eines oder mehrerer Transistoren der Intermodulationsabstand des Ausgangssignals nicht durch Nachregeln der Eingangsleistung verschlechtert wird. Bei dieser Ausführung wirken sich sowohl Temperaturerhöhungen als auch -verringerungen ungünstig aus. Positive Temperaturänderungen bewirken eine sinkende Verstärkung und - da die Eingangsleistung gleich bleibt - unmittelbar auch eine geringere Ausgangsleistung. Niedrigere Temperaturen bedeuten eine höhere Aussteuerung, was in der bereits beschriebenen Weise zu Modulationsstörungen führt. Bei beiden Verstärkerarten ist zudem der Intermodulationsabstand des Ausgangssignals auch bei Verwendung einer Vorentzerrung verschlechtert, weil die tatsächlich im Verstärker entstehenden Intermodulationsprodukte temperaturabhängig unterschiedliche Amplituden aufweisen.

Der Erfindung liegt die Aufgabe zugrunde, mit möglichst einfachen und kostengünstigen Mitteln einen Hochfrequenzleistungsverstärker der eingangs genannten Art zu schaffen, bei dem in einem großen Temperaturbereich die Hochfrequenzleistung und der für eine insoweit störungsfreie Übertragung nötige Intermodulationsabstand des Ausgangssignals unabhängig von Änderungen der Umgebungstemperatur sind.

Diese Aufgabe ist erfindungsgemäß durch die kennzeichnenden Merkmale des Patentanspruchs 1 gelöst.

Die konstante Temperaturverteilung des Kühlkörpers bewirkt aufgrund der hervorragenden Wärmeübertragung zwischen Kühlkörper und Transistorgehäuse zugleich, daß auch die für jeden Leistungstranstistor wirksame Temperatur des Kühlkörpers konstant ist, so daß die Transistoreigenschaften vollständig unabhängig von der Umgebungstemperatur gleich bleiben und temperaturabhängige Abweichungen der Hochfrequenz-Ausgangsleistung vom Sollwert und durch Temperaturänderungen verursachte Intermodulationsstörungen des Ausgangssignals wirksam vermieden sind.

Von dem angeführten Gerät der Firma Norsk Marconi ist es an sich bekannt, zur Abführung der Verlustwärme von Leistungstransistoren anstatt der herkömmlichen Konvektionskühlung Lüfter einzusetzen und dadurch den Kostenaufwand und Platzbedarf der Kühlkörper wesentlich zu verringern. Bei der erfindungsgemäßen Lösung ist dieser ohnehin benötigte Lüfter zusätzlich zur Konstanthaltung der Kühlkörpertemperaturverteilung benutzt, so daß für diesen Zweck als Mehraufwendung lediglich die kostengünstige elektronische Regelschaltung erforderlich ist. Die elektrischen Vorteile gegenüber dem eingangs beschriebenen Stand der Technik sind also praktisch ohne zusätzliche Kosten erreicht.

Besonders vorteilhaft ist es darüberhinaus, bei dieser Regeleinrichtung als Lüfterantrieb einen elektrisch kommutierten Gleichstrom-Motor zu wählen. Grundsätzlich ist selbstverständlich auch die Verwendung eines Wechselstrom-Motors möglich, der jedoch für den praktischen Einsatz weniger geeignet ist, weil er eine aufwendige Thyristorregelung bedingt und hinsichtlich seiner Lebensdauer ungünstiger ist. Weicht die der gemessenen Kühlkörpertemperatur entsprechende Spannung von der Referenzspannung ab, so wird über die Versorgungsspannung des Lüfters dessen Drehzahl und damit die den Kühlkörper an- bzw. durchströmende Luftmenge derart vergrößert bzw. verringert, daß der Spannungsunterschied zu Null wird. Mit dieser einfachen, kostengünstigen und funktionssicheren Einrichtung ist über einen weiten Temperaturbereich eine sehr schnelle Regelung auf konstante Temperatur des Kühlkörpers und damit der Leistungstransistoren erreicht.

Die Wirkung der erfindungsgemäßen Merkmale ist selbstverständlich auch dadurch erzielbar, daß die gesamte Umgebungstemperatur der Leistungsstufen durch eine Klimaanlage konstant gehalten wird. Eine derartige Lösung ist indessen erheblich aufwendiger bezüglich Kosten, Platzbedarf und Energieverbrauch.

Aus der EP-A-0 036 042 ist es zwar bekannt, die Umgebungstemperatur eines Hochfrequenzbauteils annähernd konstant zu halten. Diese Maßnahme erfolgt jedoch auf einem anderen technischen Gebiet und ist überdies durch eine geregelte Heizvorrichtung realisiert, die bei Hochfrequenz-Leistungsverstärkern gerade nicht einsetzbar ist. Ebenso geben die Mittel zur Regelung keinerlei Hinweis auf die konkreten Lösungsmerkmale des Patentanspruchs 1.

Auch die aus der US-A-2,820,855 bekannte Einrichtung beinhaltet zwar eine Regelung zur Erzielung einer konstanten Temperatur eines Hochfrequenzbauteils; diese Maßnahme betrifft indessen weder Kühlkörper aufweisende Hochfrequenz-Leistungstransistoren, noch erfolgt sie zur Kompensation temperaturabhängiger Verstärkungsänderungen, sondern zum Erreichen eines Betriebs, bei dem der gleichstrommäßige Eingangsstrom annähernd Null bzw. der Eingangswiderstand groß wird. Überdies ist auch hier eine bei der erfindungsgemäßen Einrichtung unbrauchbare Heizvorrichtung vorgesehen.

In den Unteransprüchen sind vorteilhafte Ausführungen der Erfindung angegeben.

Fließt gemäß Anspruch 2 der Luftstrom in Richtung der Kühlkörperrippen, so ist ein hoher Luftdurchsatz und vor allem eine gleichmäßige Kühlung des Kühlkörpers ermöglicht, ein Vorteil, der bei langgestreckten Kühlkörpern, wie sie in der Praxis häufig bei Verwendung mehrerer hintereinander angeordneter Transistoren eingesetzt werden, in besonders starkem Maße zum Tragen kommt.

Für den Fall durchgehender, an gegenüberliegenden Seiten offener, in etwa paralleler Rippen kann dieser Vorteil auf einfache Weise durch eine Lüfteranordnung nach Anspruch 3 noch verstärkt werden.

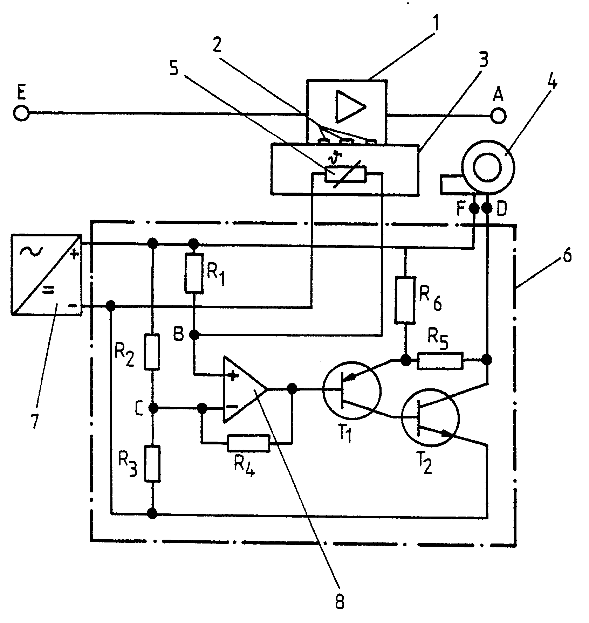

Die Figur zeigt das Prinzipschaltbild eines Hochfrequenz-Endstufenverstärkers mit der erfindungsgemäßen Temperaturregeleinrichtung.

Der Hochfrequenz-Leistungsverstärker 1 mit den Hochfrequenzanschlüssen E und A weist drei hintereinander angeordnete mit ihren Gehäusen 2 direkt auf einem Kühlkörper 3 angebrachte Leistungstransistoren auf. Die Temperaturverteilung auf dem Kühlkörper 3 und damit die jeweilige Temperatur der Leistungstransistoren wird mittels eines elektronisch kommutierten Gleichspannungslüfters 4 konstant gehalten, dessen Drehzahl entsprechend der mit einem Heißleiter 5 gemessenen Temperatur des Kühlkörpers 3 über eine elektronische Regelschaltung 6 stufenlos geregelt ist. Dabei wird die zur Abführung der Verlustwärme der Leistungstransistoren notwendige Kühlluftmenge derart verändert, daß sich am Heißleiter 5 und damit an den Transistoren unabhängig von Änderungen der Umgebungstemperatur eine gleichbleibende Temperatur einstellt. Die Drehzahlregelung des Lüftermotors ist in folgender Weise durch entsprechende Regelung seiner Versorgungsspannung realisiert: Änderungen der Umgebungs- und damit der Kühlkörpertemperatur äußern sich über einen aus dem Heißleiter 5 und einem Widerstand $R_1$ bestehenden an die Gleichspannungsanschlüsse eines stabilisierten Netzgerätes 7 angeschlossenen Spannungsteiler $R_2$, $R_3$ als Spannungsänderungen am Schaltungspunkt B. Diese werden mit einer aus dem Netzgerät 7 und dem Spannungsteiler $R_2$, $R_3$ gewonnenen, am Schaltungspunkt C anliegenden temperaturstabilisierten Referenzspannung in einem durch einen Widerstand $R_4$ gegengekoppelten Differenzverstärker 8 verglichen. Dieser ist ausgangsseitig mit der Basis eines Bipolartransistors $T_1$ und über dessen Kollektor mit der Basis eines weiteren Bipolartransistors $T_2$ verbunden, der emitterseitig am negativen Pol des Netzgerätes 7 und kollektorseitig an der negativen Anschlußklemme D des Lüfters 4 angeschlossen ist und dessen andere Anschlußklemme F zum Pluspol des Netzgerätes 7 führt. Der Emitter des Transistors $T_1$ ist mit dem Kollektor des Transistors $T_2$ über einen Gegenkopplungswiderstand $R_5$ verbunden und liegt über einen Widerstand $R_6$ an der positiven Anschlußklemme F des Lüfters 4.

Beim Auftreten einer Umgebungstemperaturänderung und dadurch einer Änderung des Heißleiterwiderstandes ergibt sich an den schaltungspunkten B und C ein Spannungsunterschied. Durch diese im Verstärker 8 verstärkte Differenzspannung werden die Bipolartransistoren $T_1$ und $T_2$ durchgesteuert, wodurch die Lüfterklemmenspannung an den Schaltungspunkten D und F und damit die Drehzahl des Lüfters 4 solange nachgestellt wird, bis der Heißleiter 5 seine Solltemperatur und somit die Differenzspannung den Wert Null erreicht hat.

Der Kühlkörper 3 weist zur Erhöhung der Kühlfläche eine Reihe von zueinander parallelen durchgehenden Rippen auf. Der Gleichspannungslüfter 4 ist derart angeordnet, daß die Kühlluft in Richtung der Rippen geblasen wird, wodurch ein hoher Luftdurchsatz und eine gleichmäßige Kühlung des Kühlkörpers 3 erreicht ist.

Mit dieser einfachen und dauerhaft sicher funktionsfähigen Regeleinrichtung sind die Temperaturen der Transistoren und damit deren elektrische Eigenschaften unabhängig von der Umgebungstemperatur konstant, sodaß temperaturabhängige Abweichungen der Verstärkerausgangsleistung vom Sollwert sowie durch Temperaturänderungen verursachte Intermodulationsstörungen des Ausgangssignals zuverlässig vermieden sind.

**Ansprüche**

1. Hochfrequenz-Leistungsverstärker mit wenigstens einen Kühlkörper aufweisenden Leistungstransistoren und einer Regelung zur Kompensation temperaturabhängiger Verstärkungsänderungen, dadurch gekennzeichnet, daß die Termperaturverteilung des Kühlkörpers (3) mittels eines von einer elektronischen Regelschaltung gesteuerten Lüfters (4) konstant gehalten ist, der einen elektronisch kommutierten Gleichstrommotor aufweist, dessen Versorgungsspannung in Abhängigkeit von der Ausgangsspannung einer Vergleicherschaltung geregelt ist, die eine der mittels eines Heißleiters (5) gemessenen Kühlkörpertemperatur entsprechende Spannung mit einer temperaturabhängigen Referenzspanung vergleicht.

2. Hochfrequenz-Leistungsverstärker nach Anspruch 1, dadurch gekennzeichnet, daß der Kühlkörper (3) nebeneinander verlaufende durchgehende Rippen aufweist und der vom Lüfter (4) erzeugte Luftstrom in Richtung der Rippen fließt.

3. Hochfrequenz-Leistungsverstärker nach Anspruch 1 oder 2, dadurch gekennzeichnet, daß je ein Lüfter an gegenüberliegenden Kühlkörperöffnungen angeordnet ist, von denen einer die Luft in den Kühlkörper einbläst und der andere sie absaugt.

**Claims**

1. A high-frequency power amplifier, having power transistors which have at least one heat sink and having a regulating means for compensating for temperature-dependent changes in gain, characterized in that the temperature distribution of the heat sink (3) is kept constant by means of a fan (4) controlled by an electronic regulating circuit, which fan has an electronically switched DC motor, the supply voltage of which is regulated as a function of the output voltage of a comparator circuit which compares a voltage, corresponding to the heat sink temperature measures by means of a high-temperature conductor (5), with a temperature-dependent reference voltage.

2. The high frequency power amplifier of claim 1, characterized in that the heat sink (3) has continuous ribs extending beside one another, and the air flow generated by the fan (4) flows in the direction of the ribs.

3. The high frequency power amplifier of claim 1 or 2, characterized in that one fan is disposed at each of opposed heat sink openings, one of which fans blows the air into the heat sink, and the other extracts it.

**Revendications**

1. Amplificateur de puissance haute fréquence, avec des transistors de puissance présentant au moins un refroidisseur et avec une régulation de compensation des variations d'amplification dues à la température, caractérisé en ce que la répartition de température du refroidisseur (3) est maintenue constante à l'aide d'un ventilateur (4), qui est commandé par un circuit électronique de régulation et qui présente un moteur à courant continu et commutation électronique dont la tension d'alimentation est régulée en fonction de la tension de sortie d'un circuit comparateur, qui compare une tension correspondant à la température du refroidisseur mesurée à l'aide d'une thermistance (5) avec une tension de référence indépendante de la température.

2. Amplificateur de puissance haute fréquence selon la revendication 1, caractérisé en ce que le refroidisseur présente des ailettes continues juxtaposées et que le courant d'air produit par le ventilateur (4) suit le sens des ailettes.

3. Amplificateur de puissance haute fréquence selon les revendications 1 ou 2, caractérisé en ce que chacune des ouvertures opposées du refroidisseur comporte un ventilateur, un de ces ventilateurs insufflant l'air dans le refroidisseur tandis que l'autre l'aspire.